(19) Europäisches Patentamt
European Patent Office
Office européen des brevets

(11) EP 2 784 820 A1

(12) **EUROPEAN PATENT APPLICATION**

(43) Date of publication:
**01.10.2014 Bulletin 2014/40**

(51) Int Cl.:
*H01L 27/146* (2006.01)

(21) Application number: **14159128.9**

(22) Date of filing: **12.03.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **25.03.2013 JP 2013062644**

(71) Applicant: **Kabushiki Kaisha Toshiba Tokyo (JP)**

(72) Inventors:
• **Honda, Hiroto**
  **Tokyo (JP)**
• **Egawa, Yoshitaka**
  **Tokyo (JP)**
• **Fujiwara, Ikuo**
  **Tokyo (JP)**

(74) Representative: **HOFFMANN EITLE Patent- und Rechtsanwälte Arabellastrasse 4 81925 München (DE)**

(54) **Solid state imaging device**

(57)    A solid state imaging device according to an embodiment includes: a pixel array including a plurality of pixel blocks on a first surface of a semiconductor substrate, each pixel block having a first to third pixels each having a photoelectric conversion element, the first pixel having a first filter with a higher transmission to a light in a first wavelength range, the second pixel having a second filter with a higher transmission to a light in a second wavelength range having a complementary color to a color of the light in the first wavelength range, and the third pixel having a third filter transmitting lights in a wavelength range including the first and second wavelength ranges; a readout circuit reading signal charges from the first to the third pixels; and a signal processing circuit processing the signal charges.

FIG. 7

EP 2 784 820 A1

**Description**

FIELD

Embodiments described herein relate generally to solid state imaging devices.

BACKGROUND

Recently, CMOS image sensors have been being actively developed. In particular, due to the miniaturization of semiconductor devices (with reduced design rules), the pixel pitch, for example, is moving toward the 1.0 μm level. With such a pixel size, the effect of wave characteristics of incident light becomes remarkable, and the reduction in amount of incident light becomes steeper than the reduction in pixel area. Therefore, a new means for improving the signal-to-noise ratio of solid state imaging devices is needed.

A CMOS image sensor of the aforementioned type generally includes color filters arranged in a Bayer array, in which a 2x2 pixel block includes one red (R) pixel, one blue (B) pixel, and two green (G) pixels arranged diagonally. The reason why each pixel block includes two G pixels is that green is highly visible to human eyes. The G pixels are used to obtain luminance (brightness) information.

Various techniques have been proposed to improve image quality from the arrangement of color filters. For example, a technique is known in which a green pixel is placed in the center of a pixel block, and white pixels used as luminance signals are placed on the up and down, left and right side of the green pixel to secure the amount of signal charge of the luminance signals. In this case, no effective method of processing white pixel data has been disclosed, and due to insufficient color information, false colors may be produced when a subject with a high spatial frequency is photographed.

BRIEF DESCRIPTION OF THE DRAWINGS

Fig. 1 is a block diagram showing a solid state imaging device according to the first embodiment.
Fig. 2 is a diagram showing a pixel block of the solid state imaging device according to the first embodiment.
Fig. 3 is a diagram showing the transmission of each color filter.
Fig. 4 is a diagram showing the sensitivity of each pixel.
Fig. 5 is a diagram showing the relationship between the transmission wavelength range and the transmission of each pixel.
Fig. 6 is a diagram showing an example of squarely arranging four pixel blocks shown in Fig. 2.
Fig. 7 is a cross-sectional view of the pixel block taken along line A-A in Fig. 6.
Fig. 8 is a cross-sectional view of the pixel block taken along line B-B in Fig. 6.
Fig. 9 is a diagram showing a layout of the depletion layers, the reading depletion layers, the transfer gates, and the diffusion layers of the solid state imaging device according to the first embodiment.
Fig. 10 is a diagram for explaining a color separation process for converting a W signal to RGB signals.
Fig. 11 is a diagram for explaining a color separation process for converting a W signal to RGB signals.
Fig. 12 is a diagram for explaining a color separation process for converting a W signal to RGB signals.
Fig. 13 is a flow chart for explaining the operation of a signal processing circuit.
Fig. 14 is a diagram showing a layout of the depletion layers, the reading depletion layers, the transfer gates, and the diffusion layers of the solid state imaging device according to the second embodiment.

DETAILED DESCRIPTION

A solid state imaging device according to an embodiment includes: a pixel array including a plurality of pixel blocks arranged in a matrix form on a first surface of a semiconductor substrate, each pixel block having a first pixel, a second pixel, and a third pixel each having a photoelectric conversion element for converting light to a signal charge, the first pixel having a first filter with a higher transmission to a light in a first wavelength range in a visible wavelength range than lights in other wavelength ranges in the visible wavelength range, the second pixel having a second filter with a higher transmission to a light in a second wavelength range having a complementary color to a color of the light in the first wavelength range than lights in other wavelength ranges in the visible light wavelength range, and the third pixel having a third filter transmitting lights in a wavelength range including the first wavelength range and the second wavelength range; a readout circuit reading signal charges photoelectrically converted by the first to the third pixels of the pixel blocks; and a signal processing circuit processing the signal charges read by the readout circuit.

Embodiments will now be explained with reference to the accompanying drawings.

(First Embodiment)

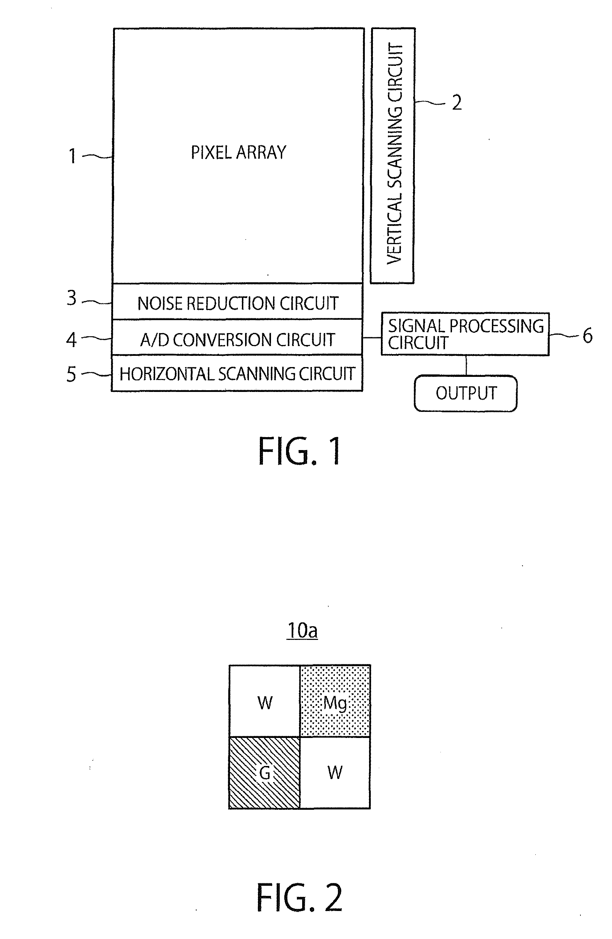

Fig. 1 schematically shows a configuration of a solid state imaging device according to the first embodiment. The solid state imaging device according to the first embodiment includes a pixel array 1 in which a plurality of pixels each having a photoelectric conversion element is arranged in a matrix form, a vertical scanning circuit 2 for sequentially supplying a drive voltage to each rows of the pixel array 1, a noise reduction circuit 3 for removing noise contained in image signals photoelectric converted by the respective pixel, an A/D conversion circuit 4 for A/D converting the image signals outputted from the noise reduction circuit 3, a horizontal scanning circuit 5 for sequentially selecting and reading A/D converted image data column by column, and a signal processing circuit 6 for signal-processing the image data, which will be described later. The signal processing circuit 6 receives image data of the pixel array 1 by sequentially receiving data of the respective pixels in a row, and then moving to the next row. The vertical scanning circuit 2, the noise reduction circuit 3, the A/D conversion circuit 4, and the horizontal scanning circuit 5 constitute a readout circuit. The readout circuit sequentially reads signals of pixels in one horizontal line simultaneously, or pixel by pixel.

The pixel array 1 includes a plurality of pixel blocks arranged in a matrix form on a first surface of a semiconductor substrate. Each pixel block includes first to third pixels. Each of the first to the third pixels includes a photoelectric conversion element for converting light to a signal charge. The first pixel has a first filter with a higher transmission with respect to light rays in a first wavelength range in a visible light wavelength range than light rays in the other wavelength ranges in the visible wavelength range. The second pixel has a second filter with a higher transmission with respect to light rays in a second wavelength range, which have a color complementary to the color of the light rays in the first wavelength range, than light rays in the other wavelength ranges in the visible wavelength range. Alternatively, the second pixel may have a second filter with a higher transmission with respect to light rays in a second wavelength range including a wavelength range that has a color complementary to the color of the first wavelength range, than light in the other wavelength ranges in the visible light wavelength range. Still alternatively, the second pixel may have a second filter with a higher transmission with respect to light rays in a second wavelength range including a peak wavelength, a color of which is complementary to the color of a peak wavelength of the first wavelength range, than light rays in the other wavelength ranges in the visible light wavelength range. The third pixel has a third filter that transmits light rays in a wavelength range including the first wavelength range and the second wavelength range.

The readout circuit reads signal charges that are photoelectrically converted by the first to the third pixels of the pixel blocks.

The signal processing circuit processes signals based on signal charges read by the readout circuit.

The pixels in the pixel array 1 are divided into a plurality of pixel blocks in the units of some adjacent pixels. For example, Fig. 2 shows an example of a pixel block 10a including two pixels in a row and two pixels in a column. The pixel block 10a includes two white (W) pixels (hereinafter also referred to as "W pixel") arranged diagonally at the upper left and the lower right squares, and a magenta (Mg) pixel (hereinafter also referred to as "Mg pixel") and a green (G) pixel (hereinafter also referred to as "G pixel") arranged diagonally at the upper right and the lower left squares.

Each W pixel has a transparent filter transmitting incident light having a visible light wavelength (for example, 400-650 nm), and guiding the visible light passing therethrough to a corresponding photoelectric conversion element. The transparent filter is formed of a material transparent to visible light, and has a high sensitivity over the entire visible light wavelength range.

The G pixel has a color filter having a high transmission with respect to light rays in the green visible light wavelength range. The Mg pixel has a color filter having a high transmission with respect to light rays in the red and the blue visible light wavelength ranges. The B pixel has a color filter having a high transmission with respect to light in the blue visible light wavelength range.

The W pixels are provided to obtain luminance information since the white pixels transmit light rays in the entire visible wavelength range. The G pixel can also be used to obtain the luminance information. Accordingly, the W pixels and the G pixel are arranged on different diagonal lines in the pixel block 10a shown in Fig. 2. In this manner, uniform level of luminance information can be detected for all the rows and the columns, which improves the luminance resolution. The G pixel and the Mg pixel are provided in addition to the W pixels to the pixel block 10a shown in Fig. 2 for obtaining color signals (information).

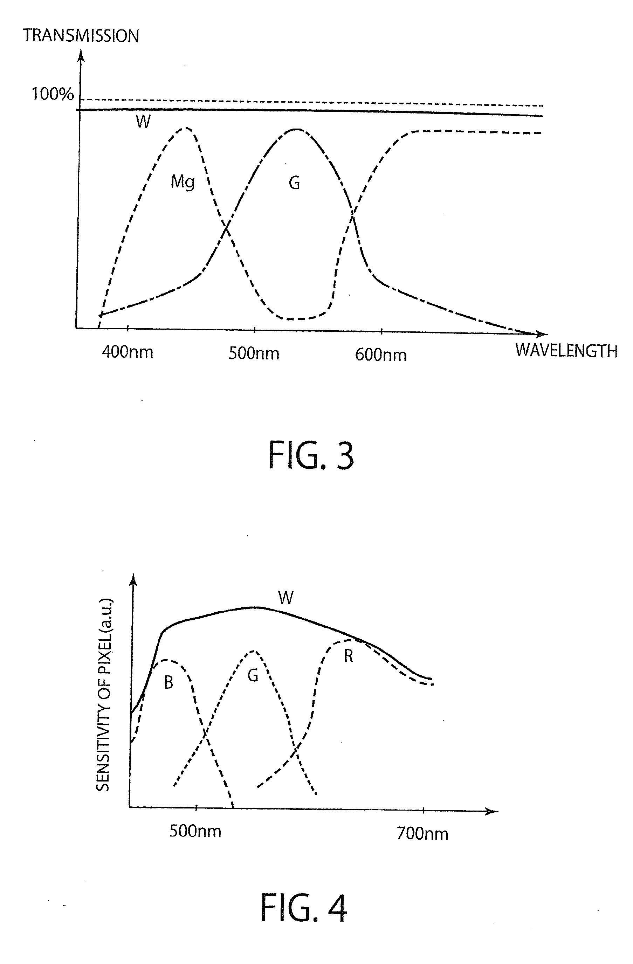

Fig. 3 shows the transmission of each color filter, and Fig. 4 shows the sensitivity of each pixel with a color filter. As shown in Fig. 3, the white (W) color filter has a transmission of 95% or more with respect to light rays in the entire visible wavelength range (about 400-700 nm), the green (G) color filter has a high transmission with respect to light rays in the wavelength range of about 500-550 nm, and the magenta (Mg) color filter has a high transmission with respect to light rays in the wavelength range of about 450-490 nm and about 600-700 nm in the visible light wavelength range.

As shown in Fig. 4, the characteristics of the sensitivity are similar to those of the transmission. The white (W) pixel has a high sensitivity with respect to light rays in the entire visible wavelength range, which is about twice the sensitivity of the green (G) pixel. The photoelectric conversion element of each pixel has a sensitivity covering the near infrared wavelength range. Therefore, unless near infrared light rays (having a wavelength of, for example, 650 nm or more) is cut, the color reproducibility is degraded. For example, if a subject emitting (reflecting) pure green light and near infrared light is imaged, the G pixel detects the green light, and the R pixel detects the near infrared light. As a result, pure green (R:G:B)=(0:1:0) in the image of the subject cannot be detected.

In order to cope with this, for example, an infrared cut-off filter for shielding light rays having a wavelength of 650 nm or more is provided between a solid-state imaging element and the subject, or the solid-sate imaging element and a lens so that only visible wavelength light is incident to the solid-state imaging element.

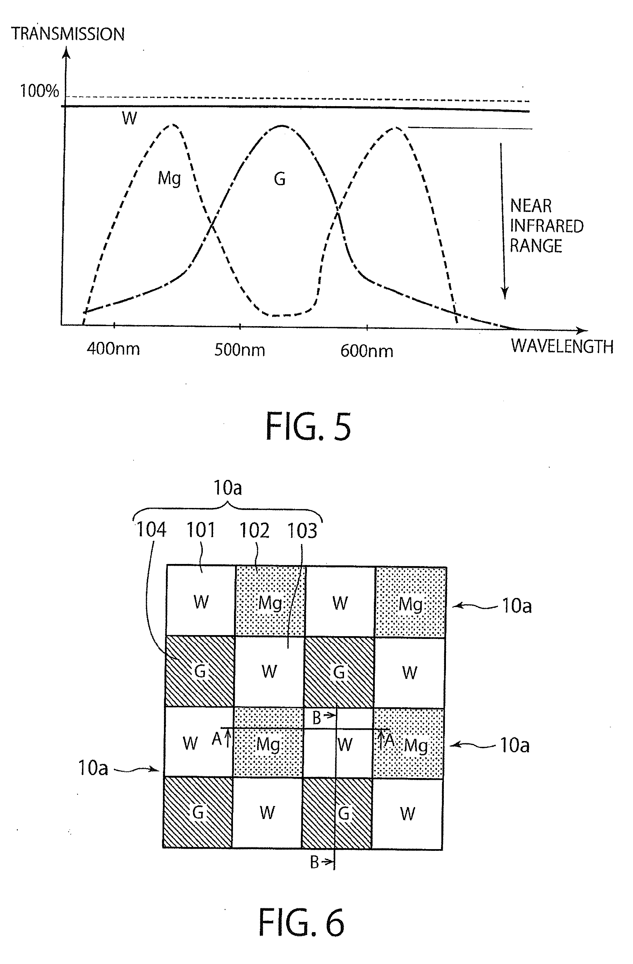

Fig. 5 shows the relationship between the passband of each pixel and the transmission in the case where an infrared cut-off filter is provided to each pixel except for the W pixel. As shown in Fig. 5, the W pixel can absorb light rays in the wavelength range (near infrared light of about 1.1 $\mu$m) on which silicon, which is a material of the substrate of the photoelectric conversion element, can perform photoelectric conversion. This is especially advantageous when an object with a low illumination is imaged. Therefore, W pixels can be used for near infrared cameras.

Fig. 6 shows an example of arranging four (two in a row and two in a column) pixel blocks 10a shown in Fig. 2. Specifically, Fig. 6 shows that four pixel blocks 10a, each including two W pixels 101, 103 diagonally arranged at the upper left and the lower right squares and a Mg pixel 102 arranged at the upper right square, and the G pixel 104 arranged at the lower left square, are arranged in two rows and two columns.

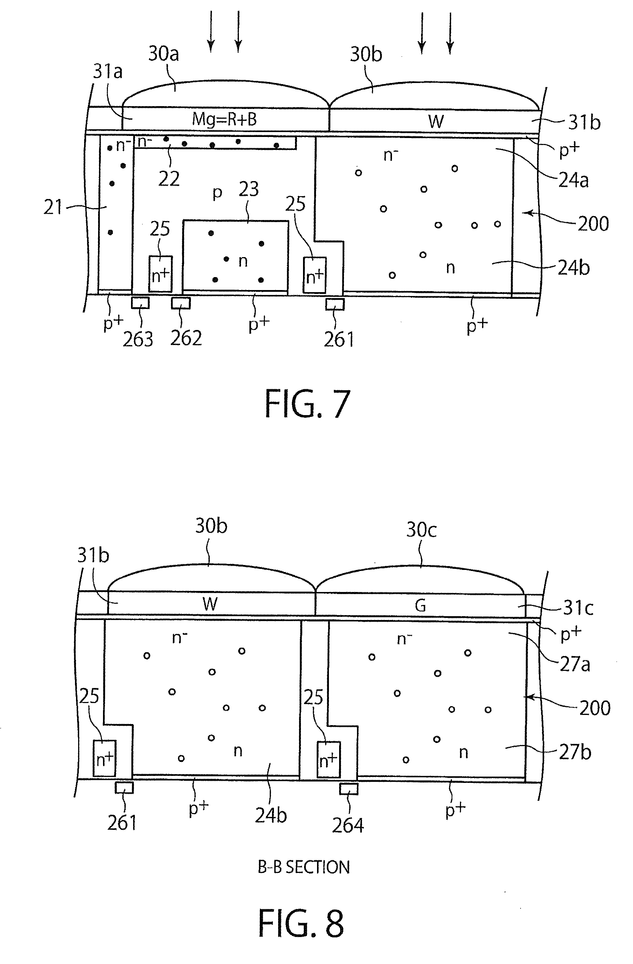

Fig. 7 shows a sectional view of the pixel block 10a taken along line A-A in Fig. 6, and Fig. 8 shows a cross-sectional view of the pixel block 10a taken along line B-B in Fig. 6. The line A-A cuts the Mg pixel 102 of one of the two pixel blocks 10a adjacent to each other and the W pixel 101 of the other, adjacent to the cut Mg pixel. The line B-B cut the W pixel 101 of the other of the adjacent pixel blocks 10a and the G pixel 104 of the other of the adjacent pixel blocks 10a. The solid-state imaging device of the first embodiment is of back side illumination type, and the front surface of the p-type semiconductor substrate 200 is facing down in Fig. 7. The back surface of the semiconductor substrate 200 is a light incident side.

The magenta color filter transmits light rays in the wavelength range including red, and light rays in the wavelength range including blue. The Mg pixel may have a photoelectric conversion element for photoelectrically converting light rays in the wavelength range including red, and a photoelectric conversion element for photoelectrically converting light in the wavelength range including blue.

The magenta color filter transmits at least red light and blue light. The Mg pixel may have a photoelectric conversion element for photoelectrically converting red light, and a photoelectric conversion element for photoelectrically converting blue light.

The two photoelectric conversion elements of the Mg pixel can be stacked in a direction perpendicular to the first surface of the semiconductor substrate.

As shown in Fig. 7, the Mg pixel includes a reading depletion layer 21 formed of an n- layer in the p-type semiconductor substrate 200, a Mg depletion layer 22 formed of an n- layer on the back side of the p-type semiconductor substrate 200, an R depletion layer 23 formed of an n layer in the front side of the p-type semiconductor substrate 200, a diffusion layer 25 formed of an n+ layer, a transfer gate 262 formed on the front side of the p-type semiconductor substrate 200 between the R depletion layer 23 and the diffusion layer 25, the transfer gate 262 transferring an R color signal component, a transfer gate 263 formed on the front side of the p-type semiconductor substrate 200 between the diffusion layer 25 and the reading depletion layer 21, the transfer gate 263 transferring a B color signal component, a Mg color filter layer 31a formed on the back side of the p-type semiconductor substrate 200, and a microlens 30a provided on the Mg color filter layer 31a.

Furthermore, as shown in Fig. 7, the W pixel includes a depletion layer 24a formed of an n- layer in the back side of the p-type semiconductor substrate 200, a depletion layer 24b formed of an n layer in the front side in the p-type semiconductor substrate 200, a transfer gate 261 formed on the front side in the p-type semiconductor substrate 200 between the depletion layer 24b and the diffusion layer 25, the transfer gate 261 transferring a W color signal component, a W color filter layer 31b formed on the back side of the p-type semiconductor substrate 200, and a microlens 30b formed on the W color filter layer 31b.

On the other hand, as shown in Fig. 8, the G pixel includes a depletion layer 27a formed of an n- layer in the back side of the p-type semiconductor substrate 200, a depletion layer 27b formed of an n layer in the front side of the p-type semiconductor substrate 200, a transfer gate 264 formed on the front side of the p-type semiconductor substrate 200 between the depletion layer 27b and the diffusion layer 25, the transfer gate 264 transferring a G color signal component, a G color filter layer 31c formed on the back side of the p-type semiconductor substrate 200, and a microlens 30c formed on the G color filter layer 31c. A p+ layer is formed on each of the depletion layers 24a, 24b, 27a, and 27b in the back side and the front side of the p-type semiconductor substrate 200.

The depletion layers in the G pixel and the W pixel preferably have a large volume in order to efficiently absorb light collected by the microlenses 30. Each Mg pixel includes two types of depletion layers for photoelectric conversion, the Mg depletion layer 22 and the R depletion layer 23, as shown in Fig. 7. The Mg depletion layer 22 receives and photoelectrically converts light rays in the visible light wavelength ranges of about 450-490 nm and about 600-700 nm, which have passed through the color filter 31a, from all the incident light rays received by the microlens 30a. The Mg depletion layer 22 is rather thin, having a thickness of about 0.5 $\mu$m in a direction parallel to the incident light, for example. Accordingly, short-wavelength components in the aforementioned Mg light rays in the wavelength range of about 450-490 nm are preferentially absorbed. As a result, the Mg depletion layer 22 mainly detects blue light rays in a wavelength range of about 450-490 nm, and slightly detects red light rays in the wavelength range of about 600-700 nm. The detected light rays are photoelectrically converted, sent to pass through the reading depletion layer 21, and accumulated around the transfer gate 263. The reading depletion layer 21 has a gradient n-type impurity concentration that increases as the distance from the light incident side increases, so that the signal charge can move along the gradient of the potential.

The accumulated charge moves to the diffusion layer 25 when the transfer gate 263 is turned on. The potential of the diffusion layer 25 is reset in advance so as to be lower than the potential of the reading depletion layer 21. Accordingly, the signal charge is completely transferred to the diffusion layer 25 via the transfer gate 263. Thereafter, the potential of the diffusion layer 25 is read, by which the signal charge detected by the Mg depletion layer 22 can be read as a voltage. The charge-voltage conversion gain at this time is determined by the sum of capacitance components connected to the diffusion layer 25.

The R depletion layer 23 detects red light rays in the wavelength range of about 600-700 nm that have not been absorbed by the Mg depletion layer 22. The electrons accumulated in the R depletion layer 23 are transferred to the diffusion layer 25 when the transfer gate 262 is turned on.

The diffusion layer 25 used to read the R depletion layer 23 in the first embodiment is the same as that used to read the Mg depletion layer 22. Accordingly, the R color signals and the Mg color signals are alternately transferred, read, and reset at different times. The diffusion layer is not shared in the W pixel and the G pixel.

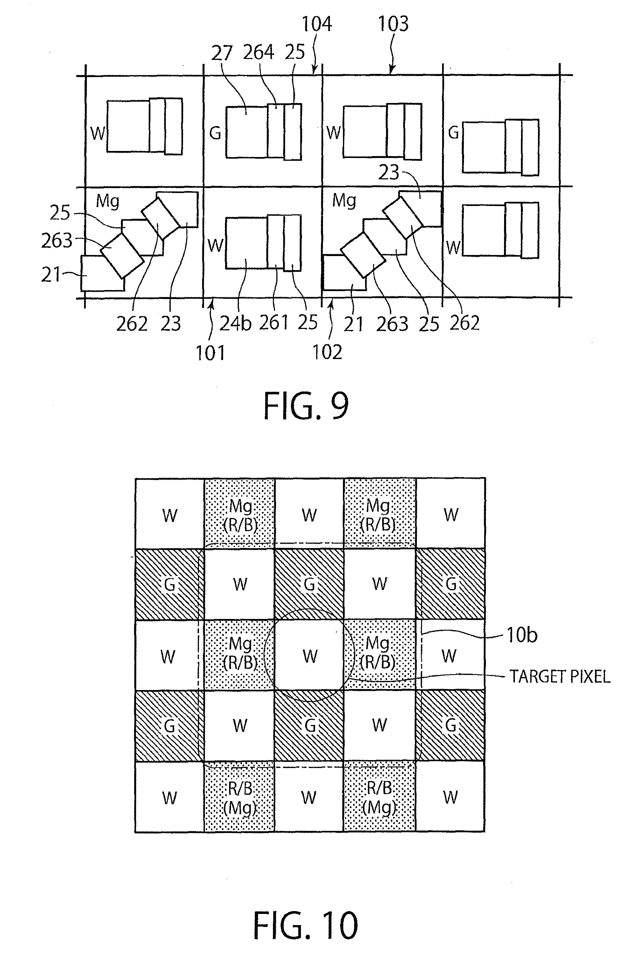

Fig. 9 shows an example of a layout of the depletion layers 22, 23, 24a, 24b, 27a, 27b, the reading depletion layers 21, the transfer gates 261, 262, 263, 264, and the diffusion layers 25 of the solid state imaging device according to the first embodiment. Fig. 9 shows the front side of the semiconductor substrate, which is opposite to the light incident side. In the Mg pixel, the reading depletion layer 21 and the R depletion layer 23 share the diffusion layer 25, and the charge transfer is performed in accordance with the signals supplied to the transfer gates 263, 262.

The signal value W of the W pixel cannot be used as RGB values, which are commonly used video signal values. Therefore, color separation should be performed by converting the white data value W of the W pixel into RGB data of three colors.

Signal values of Mg and R obtained from the Mg depletion layer 22 and the R depletion layer 23 are outputted from the Mg pixel 102. The B signal is first calculated from these signal values:

$$B = Mg - a \times R \qquad (1)$$

where a denotes the proportion of the sensitivity to red light relative to the sensitivity to the Mg color of the Mg depletion layer 22. The value of a is more than 0 and less than 1, for example 0.24, which can be uniquely determined after the manufacturing.

When RGB signals are generated from a complementary color filter, generally the signal-to-noise ratio degrades during the above subtraction process. Assuming that the expression (1) shows average values of the B, Mg, and R signals during a plurality of measurements, the dispersions of the B, Mg, and R signals, $\Delta$B, $\Delta$Mg, and $\Delta$R can be expressed as follows:

$$\Delta B^2 = \Delta Mg^2 + (a \times \Delta R)^2 \qquad (2)$$

The signal-to-noise ratio degrades since the average of signal value B is expressed by a subtraction but the dispersion thereof $\Delta$B is expressed as a sum of squares.

However, for ordinary imaging elements, it often happens that a luminance signal Y is calculated from RGB signals based on the following conversion expression, and the signal-to-noise ratio of Y is discussed:

$$Y = 0.299R + 0.587G + 0.114B \qquad (3)$$

As can be understood from the expression (3), the proportion of the B signal to the Y signal is 11.4%, which is equal to or less than 1/5 of the proportion of the G signal. Therefore, if the above expression (1) is performed, by which the B signal is generated by subtracting the R signal from the Mg signal, the degradation in the signal-to-noise ratio of the luminance signal Y is small.

Subsequently, color separation is performed by converting the W signal into RGB signals. As shown in Fig. 10, two each of Mg pixels and G pixels are present around a target W pixel. This means that two each of R pixels, G pixels, and B pixels are present around the target W pixel. The color separation is performed using the Mg pixels and the G pixels around the target W pixel in accordance with the following expressions (4) to (6):

$$R_W \leftarrow W \times K_1 \qquad (4)$$

$$G_W \leftarrow W \times K_2 \qquad (5)$$

$$B_W \leftarrow W \times K_3 \qquad (6)$$

Here, the B signal has already been calculated by the expression (1), and W represents the signal value of the W pixel. $K_1$, $K_2$, $K_3$ each represent a color ratio obtained from the RGB pixels around the target W pixel, and can be expressed by the following expressions (7) to (9):

$$K_1 = \frac{R_{average}}{(G_{average} + R_{average} + B_{average})} \qquad (7)$$

$$K_2 = \frac{G_{average}}{(G_{average} + R_{average} + B_{average})} \qquad (8)$$

$$K_3 = \frac{B_{average}}{(G_{average} + R_{average} + B_{average})} \qquad (9)$$

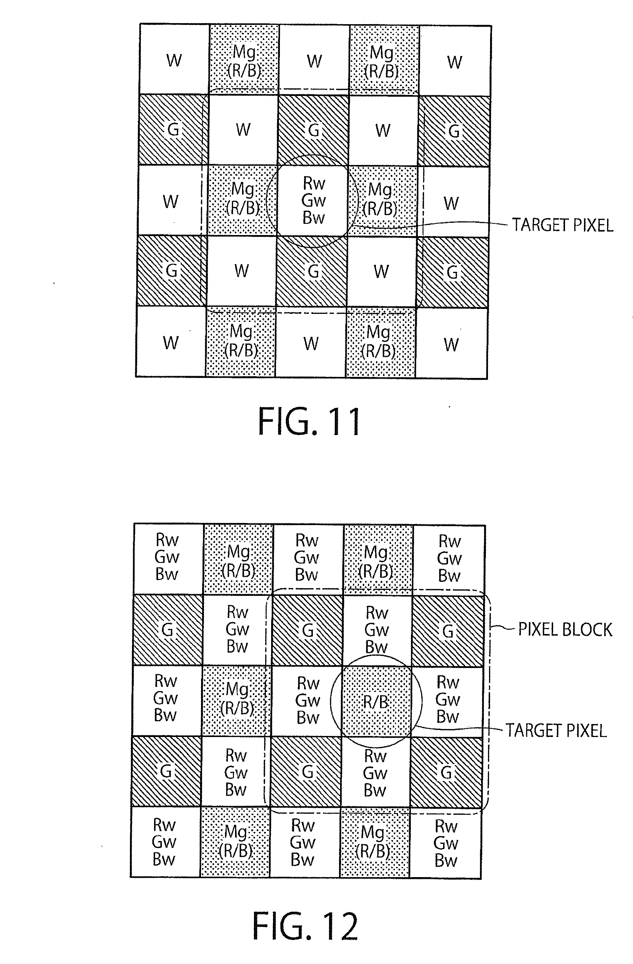

where $R_{average}$, $G_{average}$, $B_{average}$ represent averages of R, G, B color data values obtained from a plurality of pixels around the target W pixel. For example, $R_{average}$ represents an average color data value of two R pixels present in a pixel block, $G_{average}$ represents an average color data value of four G pixels, and $B_{average}$ represents an average color data value of two B pixels. Thus, the color proportions $K_1$, $K_2$, $K_3$ of the RGB pixels in a pixel block 10b shown in Fig. 10 including three rows and three columns, in which the target W pixel is placed at the center, are obtained, and these color proportions are multiplied by the luminance value (white data value W) of the W pixel itself. As a result, color separation of the W pixel can be performed without degrading the luminance resolution, and new RGB data values $R_W$, $G_W$, $B_W$ are generated at the position of the target W pixel as shown in Fig. 11.

In color separation, a range of calculation may extend over a plurality of rows. Therefore, for example, color data values of two rows are temporarily stored in a line memory, and read at the timing when the final row of the pixel block is read to perform the expressions (4) to (6).

If, for example, the color data values in a pixel block are W=200 and $(R_{average}, G_{average}, B_{average})$=(80, 100, 70), (Rw, Gw, $B_W$)=(64, 80, 56) can be obtained from the expressions (4) to (9).

Thus, when the white data value W is converted to the color data values Rw, Gw, Bw, the ratio thereof to the average color data values $R_{average}$, $G_{average}$, $B_{average}$ is (64+80+56)/(80+100+70)=4/5. Therefore, final color data values

$R_W$, $G_W$, $B_W$ can be obtained by multiplying the right sides of the expressions (4) to (6) by the reciprocal of the above value, 5/4, as a constant.

The color conversion data values $R_W$, $G_W$, $B_W$ are obtained by the multiplication and the division of the white data value W, which essentially has a high signal-to-noise ratio, and color data values, of which the signal-to-noise ratios are improved by the averaging. As a result, the signal-to-noise ratios of the generated color data values are higher than those of the R, G, B data values, respectively.

The numbers of the rows and the columns of the pixel block used for the color separation are not limited to 3x3. The capacity of the line memory used for the color separation is dependent on the number of rows of the pixel block. Thus, as the number of rows increases, the capacity of the line memory increases. Therefore, it is not preferable that the number of rows of the pixel block is increased extremely.

After the color separation is completed, an average value R' of all the R signals and the $R_W$ signals in the pixel block is calculated as shown in Fig. 12. Similarly, an average value G' of all the G signals and the $G_W$ signals in the pixel block, and an average value B' of all the B signals and the $B_W$ signals are calculated. The calculated pixel average values R', G', B' are regarded as color data values of the center pixel (target pixel) of the pixel block.

Thus, for all the pixels, final color data values R', G', B' are determined by averaging the RGB data values of the three colors and the color separation data values $R_W$, $G_W$, $B_W$ of 3x3 pixels including the target pixel placed at the center.

By repeating the above process, three color data values R', G', B' are generated for all the pixel positions. The color data value G' is obtained by color interpolation based on pixels 3/2 times those of the R data value and the B data value in the Bayer array, the color data values R', B' are obtained based on pixels 3 times those of the R data value and the B data value in the Bayer array. As a result, the signal-to-noise ratio is improved to about 2 times that of conventional devices.

Furthermore, as can be understood from Fig. 12, each row, column and diagonal line at an angle of 45° has the data of all the RGB colors in the first embodiment. As a result, no false color is generated for a subject with a high spatial frequency.

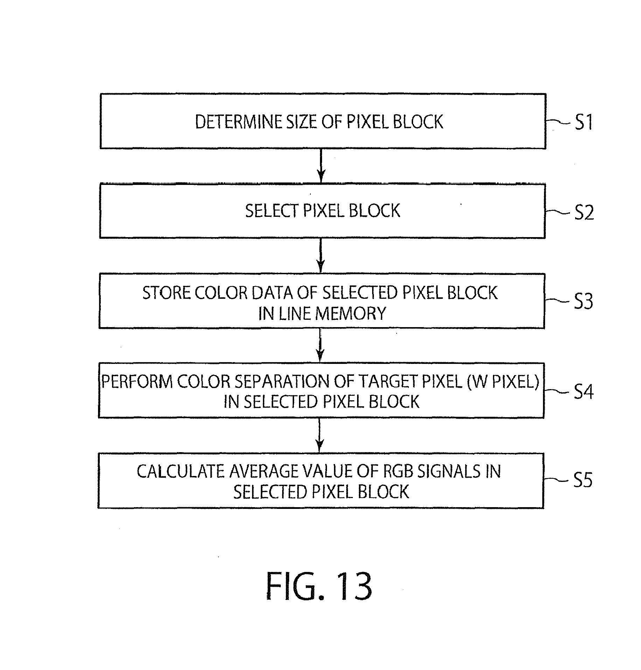

The color separation and the color data value determination described above are performed by the signal processing circuit 6 shown in Fig. 1. The signal processing circuit 6 first determines the size of the target pixel block as shown in Fig. 13 (step S1). For example, each pixel block include three rows and three columns with a W pixel located at the center as shown in Fig. 10. Subsequently, a target pixel block is selected (step S2). The color data of the selected pixel block is stored in the line memory (step S3). The line memory can be included in the signal processing circuit 6, or located outside. Thereafter, color separation of a target pixel, for example W pixel, of the selected pixel block using the color data stored in the line memory to obtain color separation data values $R_W$, $G_W$, $B_W$ (step S4). Then, the data values RGB of the three colors and the color separation data values $R_W$, $G_W$, $B_W$ in the selected pixel block are averaged to obtain final color data values R', G', B' (step S5).

The aforementioned color separation is made possible when the solid state imaging device includes the pixel block 10a having W pixels, G pixels, and Mg pixels as shown in Fig. 2. Yellow pixels, for example, can be used instead of the G pixels. In such a case, cyan pixels, which have complementary color to yellow, are used instead of the Mg pixels.

As described above, according to the first embodiment, a solid state imaging device can be provided, the solid state imaging device having a high signal-to-noise ratio for a low luminance subject, being superior in color reproducibility, and not causing degraded resolution and false colors for a subject with a high spatial frequency.

Although the pixel blocks of the first embodiment includes W pixels. G pixels, and Mg pixels, the colors of the pixels are not limited to these.

For example, a pixel block may have W pixels, first pixels, and second pixels. Each second pixel may include a first photoelectric conversion element for photoelectrically converting light rays in a wavelength range included in a wavelength range transmitted by a filter of the second pixel, and a second photoelectric conversion element for photoelectrically converting light rays in a further wavelength range included in the wavelength range transmitted by the filter of the second pixel.

If the wavelength range of the light rays transmitted by the filter of the second pixel incudes the wavelength of a first primary color and the wavelength of a second primary color, the first photoelectric conversion element may photoelectrically convert light rays in a wavelength range including the wavelength of the first primary color. The second photoelectric conversion element may photoelectrically convert light rays in a wavelength range including the wavelength of the second primary color.

(Second Embodiment)

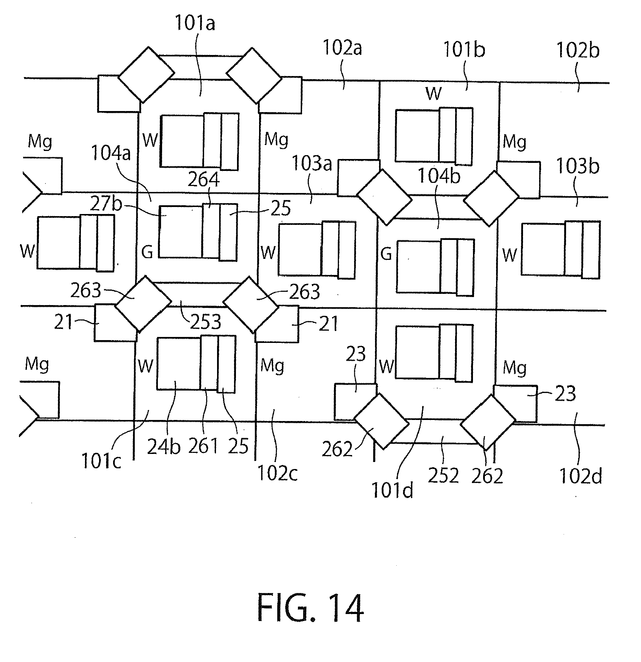

A solid state imaging device according to the second embodiment will be described with reference to Fig. 14. The solid state imaging device according to the second embodiment differs from the solid state imaging device according to the first embodiment in the layout of the depletion layers 22, 23, 24a, 24b, 27a, 27b, the reading depletion layers 21, the transfer gates 261, 262, 263, 264, and the diffusion layers 25. Fig. 14 shows the layout of the solid state imaging device of the second embodiment.

The differences between the layout of the second embodiment and the layout of the first embodiment shown in Fig. 9 are the positions of the reading depletion layers 21 in the Mg pixels 102a-102d, the positions of the transfer gates 263, 262 connected to each R depletion layer 23, and the positions of the diffusion layers 252, 253. In each of the Mg pixels 102a and 102c, the reading depletion layer 21 is located at the upper left portion of the pixel, and the R depletion layer 23 is located at the lower right portion of the pixel. However, in each of the Mg pixel 102b and the Mg pixel 102d, the reading depletion layer 21 is located at the upper right portion of the pixel, and the R depletion layer 23 is located at the lower left portion of the pixel. The R depletion layers 23 in the Mg pixel 102c and the Mg pixel 102d, for example, are connected to a common R diffusion layer 252 via the R transfer gates 262. Similarly, the reading depletion layers 21 of the pixels that are two pixels away from each other share a common B diffusion layer 253. A common signal is inputted to the two transfer gates 262 connected to the common R diffusion layer 252, and signal transfer is performed at the same time for the two pixels. In such a state, the sum of signal charges of the two pixels sent from the R depletion layers 23 is accumulated in the R diffusion layer 252 and read.

With such a structure, the sum of the number of the R diffusion layers 252 and the number of the B diffusion layers 253 becomes the same as the number of Mg pixels. Accordingly, no increase in the effective number of pixels derived from the two depletion layers in each Mg pixel is generated. This facilitates the signal processing after the pixel signals are read.

As in the first embodiment, the solid state imaging device provided according to the second embodiment has a high signal-to-noise ratio with respect to a low luminance subject, is superior in color reproducibility, and does not degrade in resolution or generate false colors for a subject having a high spatial frequency.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

## Claims

1. A solid state imaging device comprising:

   a pixel array including a plurality of pixel blocks arranged in a matrix form on a first surface of a semiconductor substrate, each pixel block having a first pixel, a second pixel, and a third pixel each having a photoelectric conversion element for converting light to a signal charge, the first pixel having a first filter with a higher transmission to a light in a first wavelength range in a visible wavelength range than lights in other wavelength ranges in the visible wavelength range, the second pixel having a second filter with a higher transmission to a light in a second wavelength range having a complementary color to a color of the light in the first wavelength range than lights in other wavelength ranges in the visible light wavelength range, and the third pixel having a third filter transmitting lights in a wavelength range including the first wavelength range and the second wavelength range;
   a readout circuit reading signal charges photoelectrically converted by the first to the third pixels of the pixel blocks; and
   a signal processing circuit processing the signal charges read by the readout circuit.

2. The device according to claim 1, wherein the second pixel includes a first photoelectric conversion element corresponding to a third wavelength range included in the second wavelength range, and a second photoelectric conversion element corresponding to a fourth wavelength range included in the second wavelength range.

3. The device according to claim 2 wherein:

   the second wavelength range includes a wavelength of a first primary color and a wavelength of a second primary color; and
   the third wavelength range includes the wavelength of the first primary color, and the fourth wavelength range includes the wavelength of the second primary color.

4. The device according to claim 2, wherein the first and the second photoelectric conversion elements are stacked in a direction perpendicular to the first surface.

5. The device according to claim 1, wherein the first filter transmits green light, and the second filter transmits magenta light.

6. The device according to claim 1, wherein each pixel block includes pixels arranged in two rows and two columns, the pixels being two first pixels, one second pixel, and one third pixel, the first pixels being arranged diagonally.

7. The device according to claim 2, wherein the signal processing circuit performs calculations:

$$C1 = P1 - a \times P2$$

$$C2 = P2$$

where P1 is a signal read by the first photoelectric conversion element, P2 is a signal read by the second photoelectric conversion element, and a is a proportion of sensitivity of the second photoelectric conversion element relative to that of the first and the second photoelectric conversion elements, the signal processing circuit outputting the signals C1 and C2.

8. The device according to claim 1, wherein the signal processing circuit determines a size of a pixel block, on which signal processing is performed, selects a pixel block having the determined size, and performs color separation of the first pixel using a signal value read from the first pixel in the selected pixel block and signal values read from the second and the third pixels that are present around the first pixel.

PIXEL ARRAY

VERTICAL SCANNING CIRCUIT

1

2

3 NOISE REDUCTION CIRCUIT

4 A/D CONVERSION CIRCUIT

5 HORIZONTAL SCANNING CIRCUIT

SIGNAL PROCESSING CIRCUIT

6

OUTPUT

# FIG. 1

10a

| W | Mg |
|---|----|
| G | W |

# FIG. 2

FIG. 3

FIG. 4

FIG. 5

FIG. 6

FIG. 7

B-B SECTION

FIG. 8

FIG. 9

FIG. 10

| W | Mg (R/B) | W | Mg (R/B) | W |
|---|---|---|---|---|
| G | W | G | W | G |
| W | Mg (R/B) | Rw Gw Bw | Mg (R/B) | W |
| G | W | G | W | G |
| W | Mg (R/B) | W | Mg (R/B) | W |

TARGET PIXEL

**FIG. 11**

| Rw Gw Bw | Mg (R/B) | Rw Gw Bw | Mg (R/B) | Rw Gw Bw |
|---|---|---|---|---|
| G | Rw Gw Bw | G | Rw Gw Bw | G |
| Rw Gw Bw | Mg (R/B) | Rw Gw Bw | R/B | Rw Gw Bw |
| G | Rw Gw Bw | G | Rw Gw Bw | G |
| Rw Gw Bw | Mg (R/B) | Rw Gw Bw | Mg (R/B) | Rw Gw Bw |

PIXEL BLOCK

TARGET PIXEL

**FIG. 12**

```
┌─────────────────────────────────────────────────┐
│          DETERMINE SIZE OF PIXEL BLOCK          │─── S1
└─────────────────────────────────────────────────┘
                        │
                        ▼
┌─────────────────────────────────────────────────┐
│               SELECT PIXEL BLOCK                 │─── S2
└─────────────────────────────────────────────────┘
                        │
                        ▼
┌─────────────────────────────────────────────────┐
│      STORE COLOR DATA OF SELECTED PIXEL BLOCK    │─── S3
│                 IN LINE MEMORY                   │
└─────────────────────────────────────────────────┘
                        │
                        ▼
┌─────────────────────────────────────────────────┐
│ PERFORM COLOR SEPARATION OF TARGET PIXEL (W PIXEL)│─── S4
│             IN SELECTED PIXEL BLOCK              │
└─────────────────────────────────────────────────┘
                        │
                        ▼
┌─────────────────────────────────────────────────┐
│     CALCULATE AVERAGE VALUE OF RGB SIGNALS IN    │─── S5
│             SELECTED PIXEL BLOCK                 │
└─────────────────────────────────────────────────┘
```

# FIG. 13

FIG. 14

Europäisches
Patentamt

European
Patent Office

Office européen
des brevets

# EUROPEAN SEARCH REPORT

**Application Number**

EP 14 15 9128

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/317048 A1 (BAI YINGJUN [US] ET AL) 29 December 2011 (2011-12-29) * paragraph [0012] - paragraph [0062] * * paragraph [0069] * * figures 1-6L * | 1-8 | INV. H01L27/146 |
| X | US 2008/179641 A1 (ASABA TETSUO [KR]) 31 July 2008 (2008-07-31) * paragraph [0023] - paragraph [0037] * * figures 2A-4B * | 1-5,7,8 | |
| A | | 6 | |
| X | US 2010/053385 A1 (CHOE WON-HEE [KR] ET AL) 4 March 2010 (2010-03-04) * paragraph [0042] - paragraph [0058] * * figures 1-3 * | 1-3,7,8 | |
| Y | | 4 | |
| A | | 5,6 | |
| Y | US 2008/157249 A1 (HWANG JOON [KR]) 3 July 2008 (2008-07-03) * the whole document * | 4 | |
| A | | 1-3,5-8 | |

**TECHNICAL FIELDS SEARCHED (IPC)**

H04N
H01L

The present search report has been drawn up for all claims

| Place of search | Date of completion of the search | Examiner |
|---|---|---|
| Munich | 30 April 2014 | Kostrzewa, Marek |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 15 9128

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2014

| Patent document cited in search report | | Publication date | Patent family member(s) | Publication date |
|---|---|---|---|---|
| US 2011317048 | A1 | 29-12-2011 | NONE | |
| US 2008179641 | A1 | 31-07-2008 | CN 101236981 A<br>JP 2008187169 A<br>KR 20080071247 A<br>TW 200834899 A<br>US 2008179641 A1 | 06-08-2008<br>14-08-2008<br>04-08-2008<br>16-08-2008<br>31-07-2008 |
| US 2010053385 | A1 | 04-03-2010 | KR 20100025362 A<br>US 2010053385 A1 | 09-03-2010<br>04-03-2010 |
| US 2008157249 | A1 | 03-07-2008 | CN 101211951 A<br>DE 102007062127 A1<br>JP 2008166818 A<br>KR 20080061483 A<br>US 2008157249 A1 | 02-07-2008<br>10-07-2008<br>17-07-2008<br>03-07-2008<br>03-07-2008 |

EPO FORM P0459

For more details about this annex : see Official Journal of the European Patent Office, No. 12/82